# EUROPÄISCHE PATENTSCHRIFT

(11) **EP 2 564 443 B1**
(45) Veröffentlichungstag und Bekanntmachung des Hinweises auf die Patenterteilung: **22.08.2018**
(21) Anmeldenummer: 11718016.6
(22) Anmeldetag: 28.04.2011
(51) Int. Cl.: H01L 51/52

(54) **FLÄCHIGER LEUCHTKÖRPER MIT VERÄNDERBARER LEUCHTDICHTE**
PLANAR LUMINOUS ELEMENT HAVING VARIABLE LUMINANCE
ÉLÉMENT LUMINEUX PLAT À LUMINANCE VARIABLE

(30) Priorität: 09.06.2010 DE 102010029843; 30.04.2010 DE 102010028427
(43) Veröffentlichungstag der Anmeldung: 06.03.2013
(73) Patentinhaber: Tridonic GmbH & Co KG, 6851 Dornbirn (AT)
(72) Erfinder: KIRCHHOF, Christian, 01099 Dresden (DE)
(74) Vertreter: Thun, Clemens
(86) Internationale Anmeldenummer: PCT/EP2011/056781
(87) Internationale Veröffentlichungsnummer: WO 2011/135047

(56) Entgegenhaltungen:
- WO-A1-2008/034405
- US-A1- 2006 087 829

## Beschreibung

Die vorliegende Erfindung bezieht sich auf eine Leuchtvorrichtung mit einem flächigen Leuchtkörper, bei der die Leuchtdichte und/oder Farbverteilung des Abstrahlbereichs des Leuchtkörpers veränderbar ist und auf ein Verfahren zum Einstellen der Leuchtdichte und/oder Farbverteilung eines flächigen Leuchtkörpers.

Auf der Basis organischer Leuchtdioden (OLED = Organic Light Emitting Diode) können neuartige Leuchtelemente verwirklicht werden. Als flächige Leuchtkörper, die gegenüber anorganischen LEDs (LED = Light Emitting Diode) eine moderate Leuchtdichte aufweisen, sind OLEDs bestens geeignet für die Herstellung flächiger diffuser Lichtquellen, wie beispielsweise Leuchtpanels. Großflächige, diffus abstrahlende Lichtquellen sind insbesondere für Anwendungen in der allgemeinen Beleuchtung erwünscht, womit OLEDs ein vielversprechendes Zukunftspotenzial für diesen Anwendungsgebiete haben. In Folge der verwendeten Dünnschichttechnologie bei der Herstellung von OLEDs kann es ferner möglich werden, flexible Leuchtkörper zu realisieren, die bisher nicht bekannte Möglichkeiten zur Beleuchtung von Räumen eröffnen.

Für praktische Anwendungen, insbesondere in der allgemeinen Beleuchtung, sind häufig gleichmäßig leuchtende OLEDs, d.h. OLEDs, die über ihre Abstrahlfläche gleichmäßig Licht abgeben, erwünscht bzw. gefordert. Analog zu anorganischen LEDs sind organische LEDs strombetriebene Bauelemente. Dies bedeutet, dass die Leuchtdichte der OLED mit dem durch die lichtemittierende, aktive Schicht der OLED fließenden Strom korreliert ist. Zur Realisierung gleichmäßig leuchtender OLEDs ist daher innerhalb der lichtemittierenden Schicht eine über die flächige Ausdehnung der OLED homogene Stromdichte erforderlich. Bei der Herstellung großflächiger Leuchtelemente stellt dies aber insbesondere eine Herausforderung dar. Typischerweise weist eine OLED mindestens eine transparente Elektrode auf, die beispielsweise mittels eines transparenten leitfähigen Oxids (TCO = Transparent Conductive Oxide) oder mittels durchsichtiger Metallschichten realisiert wird. Da die elektrische Leitfähigkeit dieser transparenten Elektrodenmaterialien allerdings gering ist, ist der Spannungsabfall innerhalb einer Elektrode nicht zu vernachlässigen. Aufgrund der Strom-Spannungscharakteristik einer OLED wirken sich geringe Spannungsunterschiede innerhalb einer Elektrodenfläche als wahrzunehmende, unerwünschte Helligkeitsunterschiede aus. Bei geforderter Homogenität der Leuchtdichte ist dadurch die maximal erreichbare Leuchtflächengröße beschränkt.

Neben gleichmäßig leuchtenden flächigen Leuchtkörpern, die primär zur funktionellen Beleuchtung dienen, wird auch nach Beleuchtungslösungen und Leuchtkörpern verlangt, deren Leuchtdichte und Abstrahlcharakteristik gezielt beeinflusst und gesteuert werden kann. Leuchtvorrichtungen mit veränderlicher Leuchtdichte sind bspw. für dekorative Beleuchtungszwecke geeignet. Zudem besteht Bedarf an Leuchtvorrichtungen, bei denen nicht nur die Leuchtdichte, sondern auch die Farbverteilung veränderbar ist. Auf diesem Wege werden neuartige Lösungen ermöglicht, um Lichtstimmungen zu erzeugen oder Räume zu inszenieren.
Der Standardaufbau einer konventionellen OLED kann wie folgt zusammengefasst werden. Im Wesentlichen besteht eine OLED bzw. ein OLED-Panel aus zwei flächig ausgebildeten Elektroden (von denen zumindest eine transparent ist), zwischen denen mindestens eine Schicht aus organischen Materialien eingebettet ist. Bei Anlegen einer geeigneten Spannung bzw. Einprägen eines geeigneten Stroms zwischen den beiden Elektroden kann in der aktiven organischen Schicht elektromagnetische Strahlung, vorzugsweise Licht, emittiert werden. Das OLED-Panel kann als so genanntes bottom- oder top-emittierendes Bauelement ausgeführt sein. Auch eine transparente Ausgestaltung der OLED ist möglich.
Aus der WO 2008/034405 A1 ist eine lichtemittierende Vorrichtung mit einer zeitlich variabel einstellbarer Leuchtdichte bekannt. Hierzu weist die Vorrichtung elektrisch leitfähige Leiterbahnen auf, die auf einer ersten Elektrodenfläche einer OELD aufgebracht sind; die Leiterbahnen werden zeitlich variabel mit unterschiedlich hohen elektrischen Strömen angesteuert. US 2006/087829 offenbart eine flächige OLED-Leuchte, die mit einem Berührungssensor integriert ist. Aufgabe der vorliegenden Erfindung ist es, eine Leuchtvorrichtung mit einem flächigen Leuchtkörper bereitzustellen, deren Leuchtdichte und/oder Farbverteilung über den Abstrahlbereich des Leuchtkörpers hinweg veränderbar ist. Zudem soll ein Verfahren geschaffen werden, bei dem die Leuchtdichte und/oder Farbverteilung über die flächige Ausdehnung des Leuchtkörpers gezielt gesteuert werden kann.
Diese Aufgabe wird durch die Leuchtvorrichtung gemäß Anspruch 1 und ein Verfahren gemäß Anspruch 12 gelöst. Vorteilhafte Weiterbildungen sind Gegenstand der abhängigen Ansprüche.
Gemäß der Erfindung wird eine Leuchtvorrichtung mit einem flächigen Leuchtkörper vorgeschlagen, der eine einen Leuchtbereich bildende Schichtanordnung mit einer ersten Elektrodenschicht, einer zweiten Elektrodenschicht und zumindest einer dazwischen liegenden lichtemittierenden Schicht aufweist. Durch Anlegen einer geeigneten Betriebsspannung bzw. Einprägen eines geeigneten Betriebsstroms zwischen den beiden Elektrodenschichten wird dabei in der aktiven lichtemittierenden Schicht elektromagnetische Strahlung, vorzugsweise Licht, emittiert. Erfindungsgemäß weist die erste Elektrodenschicht ferner mindestens zwei lateral über den Leuchtbereich hinweg beabstandete Kontaktbereiche auf, über die mittels einer Signalquelle ein elektrisches Steuersignal anlegbar ist. Der Grundgedanke der Erfindung ist folgender: Durch Anlegen eines Steuersignals, bspw. in Form einer Steuerspannung oder eines Steuerstroms, zwischen zwei über den Leuchtbereich lateral beabstandeten Kontaktbereichen kann über die Elektrodenschicht in lateraler Richtung ein Spannungsgefälle eingestellt werden. Wird nun eine Betriebsspannung bzw. ein Betriebsstrom zwischen den beiden Elektrodenschichten angelegt, so wird die Verteilung der Ladungsträger über die Ausdehnung der Elektrode in lateraler Richtung durch das angelegte Spannungsgefälle beeinflusst. Bei flächigen Leuchtkörpern, bei denen die Leuchtdichte von der Verteilung der Ladungsträger über die Elektrodenfläche abhängt, kann die Leuchtdichte und der Helligkeitsverlauf durch das angelegte Steuersignal in lateraler Richtung zwischen den zwei Kontaktbereichen variiert werden. Bei organischen Leuchtdioden hängt die Leuchtdichte von den in die lichtemittierende aktive Schicht injizierten Ladungsträgern ab und somit von der Verteilung der Ladungsträger über die Elektrodenfläche.

Erfindungsgemäß kann eine Mehrzahl weiterer Kontaktbereiche an der ersten Elektrodenschicht jeweils voneinander lateral beabstandet angeordnet sein, über die ein Steuersignal anlegbar ist. Die einzelnen Kontaktbereiche können dabei selektiv ansteuerbar sein, sodass zwischen einem beliebigen Paar von Kontaktbereichen ein Steuersignal, bspw. in Form eines Spannungssignals oder einer Steuerspannung, angelegt werden kann. Die Kontaktbereiche können eine beliebige (geometrische) Form aufweisen und bevorzugt an die Geometrie des Leuchtbereichs angepasst sein. So können jeweils einzelne oder alle Kontaktbereiche im Wesentlichen punktförmig, oder streifenförmig oder entsprechend in Kombinationen davon ausgebildet sein. Durch eine größere Anzahl von Kontaktbereichen, an denen ein Steuersignal angelegt werden kann, wird eine feiner ortsaufgelöste Steuerung der Leuchtdichteverteilung ermöglicht.

Bevorzugt sind die Kontaktbereiche zum Anlegen eines Steuersignals an die hochohmigere Elektrodenschicht vorgesehen. Typischerweise ist dies eine transparente Elektrodenschicht.

Durch Variation der Polung, des Spannungsverlaufs, des Stromverlaufs und des Taktes des Steuersignals kann die Verteilung der Leuchtdichte über dem Leuchtbereich ortsaufgelöst variiert werden. Wird das Steuersignal getaktet oder gepulst ausgeführt, so kann die Verlustleistung, die notwendigerweise mit dem Anlegen eines Steuersignals einhergeht, verringert werden.

In einer erfindungsgemäßen Ausführungsform kann mindestens eine Elektrodenschicht strukturiert ausgebildet sein. Dies bedeutet, dass der Flächenwiderstand über die Fläche der Elektrode nicht homogen und konstant ist, sondern durch Strukturierung gezielten Variationen unterliegt. So kann bspw. eine Elektrode mittels Aussparungen (d.h. Bereiche mit sehr hohem Widerstand) strukturiert sein. Es können damit Anzeigeelemente realisiert werden.
Erfindungsgemäß kann durch geeignete Strukturierung einer Elektrodenschicht zwischen einem Paar von Kontaktbereichen, an die ein Steuersignal anlegbar ist, der Verlauf der Leuchtdichte annähernd stufenlos (kontinuierlich) oder stufenförmig (diskret) variiert werden. Weist die Elektrodenschicht einen annähernd konstanten Flächenwiderstand auf bzw. ändert sich der Flächenwiderstand über die Elektrodenfläche in einer annähernd kontinuierlichen Weise, so ist der Leuchtdichteverlauf über die Elektrodenfläche annähernd kontinuierlich (stufenlos) und kann durch Anlegen eines Steuersignals in kontinuierlicher (stufenloser) Weise variiert werden. Ist die Elektrode in diskreter Weise, beispielsweise mittels paralleler Aussparungen, strukturiert, kann entsprechend der Form der Aussparungen eine stufenförmige Änderung des Leuchtdichteverlaufs über dem Leuchtbereich erreicht werden. Auf diese Weise können somit kostengünstige Pegelanzeigen realisiert werden.
In einer bevorzugten Ausführungsform kann durch Anlegen eines elektrischen Steuersignals an zwei lateral über den Leuchtbereich hinweg beabstandete Kontaktbereiche einer Elektrode der Farbverlauf zwischen den zwei Kontaktbereichen variiert werden.

Erfindungsgemäß umfasst die Leuchtvorrichtung ferner Mittel, die eine Detektion einer Annäherung eines Objekts oder Berührung der Oberfläche des flächigen Leuchtkörpers ermöglichen. Die Detektion einer Annäherung oder Berührung erfolgt ortsaufgelöst. Erfindungsgemäß ist eine Kapazitätserfassungseinrichtung zum Erfassen eines Kapazitätsparamters vorgesehen. Die Kontaktbereiche an der ersten Elektrodenschicht, über die ein Steuersignal anlegbar ist, dienen zur Erfassung eines Kapazitätsparameters. Basierend auf dem erfassten Kapazitätsparameter kann die Position eines Objekts, das sich der Leuchtvorrichtung nähert oder die Oberfläche der Leuchtvorrichtung berührt, ermittelt werden. Erfindungsgemäß kann die Leuchtdichte- und/oder der Farbverteilung der Leuchtvorrichtung in Abhängigkeit von der Position des Objekts gesteuert werden.
Die vorliegende Erfindung betrifft ferner ein Verfahren zur Steuerung der Leuchtdichte- und/oder Farbverteilung des Leuchtbereichs einer Leuchtvorrichtung. Die Leuchtvorrichtung weist dabei einen flächigen Leuchtkörper auf, der eine einen Leuchtbereich bildende Schichtanordnung mit einer ersten Elektrodenschicht, einer zweiten Elektrodenschicht und mindestens einer lichtemittierenden Zwischenschicht, die zwischen den beiden Elektrodenschichten angeordnet ist, aufweist. Die erste Elektrodenschicht weist ferner mindestens zwei lateral über den Leuchtbereich beabstandete Kontaktbereiche auf. Erfindungsgemäß wird die Leuchtdichte- und/oder Farbverteilung über den Leuchtbereich der Leuchtvorrichtung eingestellt, indem mindestens ein Steuersignal, bspw. in Form einer Steuerspannung oder eines Steuerstroms, an die erste Elektrodenschicht über die zwei lateral beabstandeten Kontaktbereiche angelegt wird. Zudem wird eine Betriebsspannung bzw. ein Betriebsstrom zwischen den beiden Elektrodenschichten angelegt.
Das erfindungsgemäße Verfahren weist ferner einen Schritt auf, bei dem mindestens ein Kapazitätsparameter an den Kontaktbereichen der ersten Elektrodenschicht erfasst wird. Erfindungsgemäß wird basierend auf dem erfassten Kapazitätsparameter die Position eines Objekts, welches sich der Leuchtvorrichtung annähert oder die Oberfläche der Leuchtvorrichtung berührt, ermittelt. Erfindungsgemäß kann die Leuchtdichte- und/oder Farbverteilung der Leuchtvorrichtung in Abhängigkeit von der Position des Objekts gesteuert werden. Somit wird also eine interaktive Steuerung der Leuchtdichte- und/oder Farbverteilung der Leuchtvorrichtung durch den Benutzer ermöglicht.
Bevorzugt ist der erfindungsgemäße flächige Leuchtkörper aus organische Leuchtdioden aufgebaut, jedoch ist die Erfindung nicht darauf beschränkt. Die Erfindung kann für beliebige flächige Leuchtkörper angewandt werden, bei denen sich eine lichtemittierende Schicht zwischen zwei flächigen Elektroden befindet, wie beispielsweise bei einer lichtemittierenden elektrochemischen Zelle (LEC Light-emitting Electrochemical Cell).
Nachfolgend soll die Erfindung anhand der beiliegenden Zeichnungen näher erläutert werden. Es zeigt:
Fig. 1 eine schematische Seitenansicht einer Leuchtvorrichtung mit einem flächigen Leuchtkörper;
Fig. 2 eine schematische Darstellung einer Elektrodenschicht, an die ein Steuersignal anlegbar ist, mit einer schematischen Ansteuerschaltung;
Fig. 3 eine schematische Darstellung einer strukturierten Elektrodenschicht, an die ein Steuersignal anlegbar ist, mit einer schematischen Ansteuerschaltung;
Fig. 4 eine schematische Darstellung einer Elektrodenschicht mit mehreren Kontaktbereichen, an die Steuersignale anlegbar sind, mit einer schematischen Ansteuerschaltung;
Fig. 5 eine schematische Darstellung einer Elektrodenschicht mit mehreren Kontaktbereichen, an die Steuersignale anlegbar sind, mit einer schematischen Ansteuerschaltung;
Fig. 6 eine schematische Darstellung einer strukturierten Elektrodenschicht mit mehreren Kontaktbereichen, an die Steuersignale anlegbar sind, mit einer schematischen Ansteuerschaltung;
Fig. 7 eine schematische Seitenansicht einer Leuchtvorrichtung mit einem berührungsempfindlichen flächigen Leuchtkörper gemäß einem Ausführungsbeispiel der vorliegenden Erfindung;
Fig. 8 eine schematische Darstellung einer Leuchtvorrichtung mit einer Mehrzahl von flächigen Leuchtkörpern gemäß einem weiteren Ausführungsbeispiel der vorliegenden Erfindung;
Bevor nachfolgend die vorliegende Erfindung im Detail anhand der Zeichnungen näher erläutert wird, wird darauf hingewiesen, dass funktionsgleiche oder gleichwirkende Elemente in den Figuren mit den gleichen oder ähnlichen Bezugszeichen versehen sind, so dass die in unterschiedlichen Ausführungsbeispielen dargestellte Beschreibung dieser Elemente untereinander austauschbar ist bzw. aufeinander angewendet werden kann.

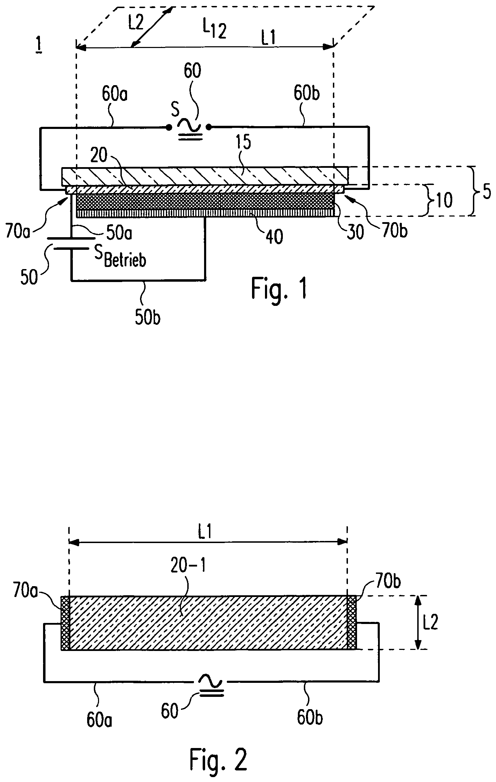

Fig. 1 zeigt eine schematische Seitenansicht einer Leuchtvorrichtung 1 mit einem flächigen Leuchtkörper 5 die kein Teil der beanspruchten Erfindung ist. Der flächige Leuchtkörper 5, der beispielsweise als ein OLED-Panel ausgebildet sein kann, weist eine Schichtanordnung 10 auf, die an einem Substrat 15 aufgebracht sein kann. Weiters weist die aktive Schichtanordnung 10 eine flächig ausgebildete erste Elektrodenschicht 20, eine flächig ausgebildete zweite Elektrodenschicht 40 sowie mindestens eine lichtemittierende Zwischenschicht 30 auf, die zwischen der ersten und der zweiten Elektrodenschicht angeordnet ist. Das OLED-Panel kann starr (als OLED-Platte) ausgebildet sein, wenn beispielsweise eine Glasplatte als Substrat verwendet wird. Das OLED-Panel kann auch flexibel (als OLED-Folie) ausgebildet sein, wenn bspw. eine Folie als Substrat verwendet wird. Als Substratmaterialien sind beispielsweise auch Metallfolien denkbar, bei denen eine isolierende Schicht aufgebracht wird, bevor der aktive Schichtstapel 10 gebildet wird.

Das OLED-Panel kann als sogenanntes bottom- oder top-emittierendes Bauteil ausgeführt sein. Die vorliegende Erfindung wird hier primär anhand einer so genannten bottom-emittierenden OLED erläutert, der erfindungsgemäße Gedanke lässt sich natürlich auch auf eine top emittierende OLED anwenden. Bei einer bottom-emittierenden OLED ist sowohl das Substrat 15 als auch die erste Elektrodenschicht 20 lichtdurchlässig. Die erste Elektrodenschicht 20 kann beispielsweise mittels eines transparenten leitfähigen Oxids (TCO = Transparent Conductive Oxide) wie beispielsweise Indium-Zinn-Oxid (ITO = Indium Tin Oxide) oder mittels einer dünnen durchsichtigen Metallschicht realisiert werden. Die Schichtdicke er ITO Schicht kann beispielsweise eine Größenordnung von 100 nm betragen, wobei häufig die ITO-Schicht auf ein Glassubstrat aufgebracht wird und als Anode dienen kann. Darauf folgt eine organische Schicht oder eine organische Schichtstruktur, die teilweise bis zu 7 Sublagen oder Schichten aufweisen kann, mit einer Schichtdicke von ca. 100 bis 200 nm. Abschließend wird eine metallische Kathode, die beispielsweise Aluminium aufweisen kann, mit einer Schichtdicke von ca. 100 bis 500 nm Dicke aufgebracht. Die gesamte Anordnung kann ferner zum Schutz gegen die Umgebungsatmosphäre, d.h. gegen Sauerstoff und Luftfeuchtigkeit, noch mit einer Verkapselung versehen sein. Bei einer transparenten OLED ist auch die zweite Elektrodenschicht 40 aus lichtdurchlässigem Material gebildet.

Durch Anlegen einer geeigneten Betriebsspannung bzw. Einprägen eines geeigneten Betriebsstroms S_{Betrieb} zwischen den beiden Elektrodenschichten 20, 40 kann in der aktiven lichtemittierenden Schicht 30 elektromagnetische Strahlung, vorzugsweise Licht, emittiert werden. Dazu ist eine elektrische Energiequelle 50 vorgesehen, die mittels einer ersten Anschlussleitung 50a und einer zweiten Anschlussleitung 50b mit der ersten Elektrodenschicht 20 und der zweiten Elektrodenschicht 40 verbunden ist, und eine geeignete Betriebsspannung bzw. einen geeigneten Betriebsstroms S_{Betrieb} zwischen den beiden Elektrodenschichten zur Verfügung stellt. Die Kontaktierung ist hier schematisch dargestellt. Da die elektrische Leitfähigkeit der transparenten Elektrode verhältnismäßig gering ist, kann dies bei großflächigen Leuchtelementen häufig eine Inhomogenität der Leuchtdichteverteilung bewirken. Um nun die Homogenität der Leuchtdichteverteilung des abgestrahlten Lichts über den Abstrahlbereich L₁₂ zu verbessern, können mehrere Kontaktierungsbereiche an einer oder beiden Elektroden vorgesehen sein, über die der Leuchtkörper 5 mit einer Betriebsspannung bzw. einem Betriebsstrom S_{Betrieb} versorgt wird. Diese Mehrfacheinspeisungen können durch eine Aufteilung zumindest einer der Anschlüsse 50a, 50b auf mehrere Kontaktierungsbereiche für den flächigen Leuchtkörper 5 realisiert sein.

In der Fig. 1 ist ferner der Leuchtbereich (Abstrahlbereich) L₁₂ des flächigen Leuchtkörpers 5 mit den Abmessungen L1, L2 angedeutet. Der Leuchtbereich L₁₂, gebildet durch einen Bereich, an dem sich die beiden Elektroden überlappen, hat eine rechteckige Form und weist eine Längsausdehnung L1 und eine (normal zur Zeichenebene von Fig. 1) Querausdehnung L2 auf. Die rechteckige Grundform des OLED-Panels 5 ist dabei rein beispielhaft. Es sind OLED-Panels mit beliebiger Geometrie als Grundform und einer beliebigen Form des Leuchtbereichs L₁₂ denkbar, wobei sich auch die Grundform (die Form des Substrats) von der Form des Leuchtbereichs L₁₂ unterscheiden kann.
Erfindungsgemäß weist die erste Elektrodenschicht 20 ferner mindestens zwei lateral über den Leuchtbereich L₁₂ hinweg beabstandete Kontaktbereiche 70a, 70b auf, über die mittels einer Signalquelle 60 ein elektrisches Steuersignal S_{Steuer} anlegbar ist. Die Signalquelle 60 ist mittels einer ersten und einer zweiten Anschlussleitung 60a, 60b mit den Kontaktbereichen 70a, 70b elektrisch verbunden. Bevorzugt wird das Steuersignal an eine Elektrodenschicht mit geringerer Leitfähigkeit, beispielsweise an die transparente Elektrode, angelegt. Es wird dabei die relativ geringe Leitfähigkeit der Elektrodenschicht ausgenützt, um mittels des Steuersignals S_{Steuer} einen steuerbaren Spannungsabfall zwischen den beiden lateral über den Leuchtbereich L₁₂ hinweg beabstandeten Kontaktbereichen 70a,70b einzustellen, und ein Kurzschluss zwischen den beiden Kontaktbereichen 70a, 70b vermieden werden kann. Die geringe Leitfähigkeit der ersten Elektrodenschicht 20 kann beispielsweise in einem Bereich von etwa 1 bis 50 Ohm/square liegen.
Mittels des Steuersignals S_{Steuer} kann nun über die Elektrodenschicht in lateraler Richtung zwischen den über den Leuchtbereich lateral beabstandeten Kontaktbereichen 70a, 70b ein Spannungsgefälle eingestellt werden. Durch das angelegte Spannungsgefälle wird die Verteilung der Ladungsträger über die Fläche der Elektrode in lateraler Richtung beeinflusst. Die Leuchtdichte und damit der Helligkeitsverlauf hängt von der Ladungsträgerrekombination in der lichtemittierenden Schicht und somit indirekt von den in die lichtemittierende aktive Schicht injizierten Ladungsträgern ab, wobei diese wiederum von der Verteilung der Ladungsträger über die Elektrodenfläche abhängt. Durch das angelegte Steuersignal S_{Steuer} kann dadurch die Leuchtdichte und damit der Helligkeitsverlauf in lateraler Richtung zwischen den zwei Kontaktbereichen 70a,70b variiert werden.

Bei der in Fig. 1 dargestellten Beispiel eines bottom-emittierenden Bauelements sind die Kontaktbereiche 70a, 70b an der dem Substrat näherliegenden transparenten Elektrode 20 angeordnet. Es kann aber auch vorgesehen sein, dass ein Steuersignal S_{Steuer} über die zweite Elektrodenschicht 40 angelegt wird und dazu die Kontaktbereiche 70a, 70b an der zweiten Elektrode angeordnet sind. Dies kann bspw. bei einem top-emittierenden optoelektronischen Bauteil der Fall sein, wo die zweite Elektrodenschicht 40 transparent ist, oder auch bei einer transparenten OLED, bei der beide Elektrodenschichten lichtdurchlässig ausgebildet sind.

Das Steuersignal S_{Steuer} kann als Gleichsignal oder Wechselsignal, insbesondere als Taktsignal mit einem einstellbaren Tastverhältnis ausgebildet sein. Um die Verlustleistung, die notwendigerweise mit dem Anlegen eines Steuersignals einhergeht, möglichst niedrig zu halten, kann das Tastverhältnis verringert werden.

Um einen Kurzschluss oder sehr hohe elektrische Verluste zwischen der elektrischen Energiequelle 50, die die Betriebsspannung bzw. den Betriebsstrom S_{Betrieb} bereitstellt, und der Signalquelle 60, mittels der ein elektrisches Steuersignal S_{Steuer} angelegt wird, zu vermeiden, sollten die Kontaktbereiche, die von den Anschlussleitungen 50a,50b der Energiequelle 50 kontaktiert werden, von den Kontaktbereichen 70a, 70b, die von den Anschlussleitungen 60a,60b der Signalquelle 60 kontaktiert werden, möglichst ausreichend beabstandet sein.

Die Kontaktbereiche zur Betriebsstromversorgung bzw. die Kontaktbereiche 70a,70b, an die ein Steuersignal anlegbar ist, können eine beliebige (geometrische) Form aufweisen und bevorzugt an die Geometrie des Leuchtbereichs L₁₂ angepasst sein. So können jeweils einzelne oder alle Kontaktbereiche im Wesentlichen punktförmig, oder streifenförmig oder entsprechend in Kombinationen davon ausgebildet sein.

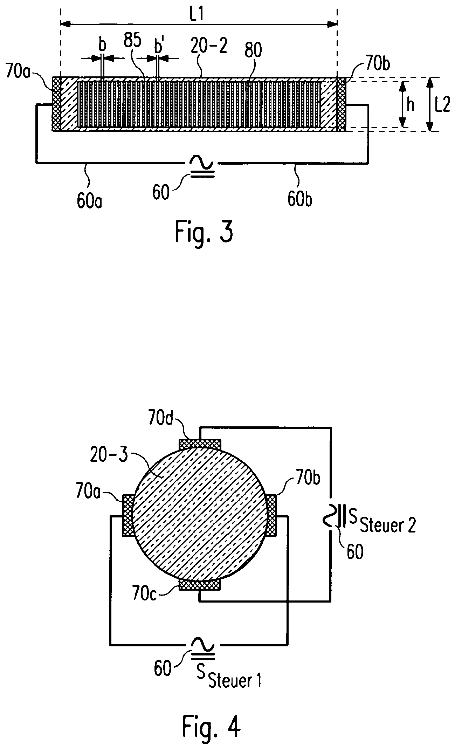

In Fig. 2 und Fig. 3 sind verschiedene Beispiele für eine mögliche Strukturierung einer Elektrodenschicht der Leuchtvorrichtung dargestellt. Dabei wird jeweils eine schematische Draufsicht auf die erste Elektrodenschicht 20-1 bzw. 20-2 mit einem Paar lateral über den Leuchtbereich L₁₂ beabstandeten Kontaktbereichen 70a,70b, an die mittels der Anschlussleitungen 60a,60b ein Steuersignal S_{Steuer} angelegt werden kann, gezeigt. Die restlichen Funktionselemente der Leuchtvorrichtung 1, wie sie bspw. in Fig. 1 dargestellt sind, sind zur Vereinfachung der Darstellung weggelassen worden. Durch das angelegte Steuersignal S_{Steuer} kann die Leuchtdichte und damit der Helligkeitsverlauf in der Richtung L1 zwischen den zwei Kontaktbereichen 70a,70b variiert werden.

In der erfindungsgemäßen Ausführungsform von Fig. 2 ist die Elektrodenschicht homogen ausgebildet, d.h. die Elektrodenschicht 20-1 weist über die Leuchtfläche einen annähernd konstanten Flächenwiderstand auf. Der Leuchtdichteverlauf über die Elektrodenfläche ist daher annähernd kontinuierlich (stufenlos) und kann durch Anlegen eines geeigneten Steuersignals S_{Steuer} über die Elektrodenfläche in kontinuierlicher (stufenloser) Weise variiert werden.

In der erfindungsgemäßen Ausführungsform von Fig. 3 weist die Elektrodenschicht 20-2 Strukturierungen auf. Dies bedeutet, dass der Flächenwiderstand über die Fläche der Elektrode nicht näherungsweise homogen und konstant ist, sondern durch Strukturierung gezielten Variationen unterliegt. In der bevorzugten Ausführungsform von Fig. 3 ist die Elektrode 20-2 mittels Aussparungen 80 (d.h. Bereiche mit sehr hohem Widerstand) strukturiert. Die Aussparungen 80 sind durch Stege 85 voneinander getrennt. Die Aussparungen 80 können wie in Fig. 3 beispielsweise rechteckig sein und durch eine Breite b und Höhe h gekennzeichnet sein. Die Stege 85 können beispielsweise eine Breite b' aufweisen. Wie in Fig. 3 dargestellt, sind die durch Stege 85 getrennten Aussparungen 80 länglich und quer zur Verbindungslinie zwischen den Kontaktbereichen 70a, 70b angeordnet. Da die Aussparungen annähernd elektrisch isolierend sind, ergeben sich für einen Betriebsstrom S_{Betrieb} sprunghafte Widerstandsänderungen innerhalb der Elektrodenschicht. Mittels eines angelegten Steuersignals S_{Steuer} kann nun entsprechend der Form der Aussparungen eine stufenförmige Änderung des Leuchtdichteverlaufs über dem Leuchtbereich erreicht werden, wobei der Leuchtdichteverlauf im Wesentlichen abrupt zwischen zwei benachbarten Stegen 85 der strukturierten Elektrodenschicht 20-2 von einem leuchtenden Zustand in einen nicht-leuchtenden Zustand oder abgestuft über mehrere benachbarte Stege 85 von einem leuchtenden Zustand in einen nicht-leuchtenden Zustand (oder umgekehrt) übergehen kann. Auf diesem Wege können einfache Anzeigeelemente, insbesondere Pegel- oder Außensteuerungsanzeigen, realisiert werden. Es können sowohl die Breite b der Aussparungen 80 als auch die Breite b' der Stege 85 je nach gewünschter Anwendung gewählt werden. Je größer die Aussparungen 80 zwischen den Stegen 85 dimensioniert sind, umso grob-stufiger ist Änderung des Leuchtdichteverlaufs über dem Leuchtbereich L₁₂. Die Erfindung ist nicht auf rechteckförmige Aussparungen beschränkt, es sind prinzipiell auch andere Formen der Strukturierung der Elektrodenschicht denkbar.
Die vorangehenden Ausführungsbeispiele erlauben, den Leuchtdichteverlauf über dem Leuchtbereich L₁₂ im Wesentlichen in einer Richtung zu steuern. In den folgenden Ausführungsformen sind zusätzliche Kontaktbereiche 70c-d, 70c-f an einer Elektrodenschicht vorgesehen, an denen ein Steuersignal angelegbar ist. Damit wird eine feinere ortsaufgelöste Steuerung der Leuchtdichteverteilung ermöglicht.

In dem Beispiel in Fig. 4 ist eine Leuchtvorrichtung mit einem flächigen Leuchtkörper 5 gezeigt, welcher beispielsweise einen kreisscheibenförmige Leuchtbereich L₁₂ aufweist. Diese Leuchtvorrichtung ist kein Teil der beanspruchten Erfindung. Die erste Elektrodenschicht 20-3 ist durch 2 Paare von Kontaktbereichen 70a, 70b und 70c, 70d kontaktiert, die jeweils um 90° zueinander verdreht an der ersten Elektrodenschicht 20-3 angeordnet sind. Die Kontaktbereiche 70a, 70b und 70c, 70d sind jeweils über zwei Steuersignalquellen 60 mit einem Steuersignal S_{Steuer1} und S_{Steuer2} getrennt voneinander individuell ansteuerbar. Durch eine geeignete Ansteuerung der beiden Kontaktbereichspaare 70a, 70b und 70c, 70d wird nun eine Steuerung der Leuchtdichteverteilung in zwei Richtungen möglich und somit über eine Fläche variierbar. Die beiden Steuersignal S_{Steuer1} und S_{Steuer2} können dabei auch nur durch eine einzelne Signalquelle 60 erzeugt werden, wobei bspw. ein Multiplexverfahren angewandt wird.

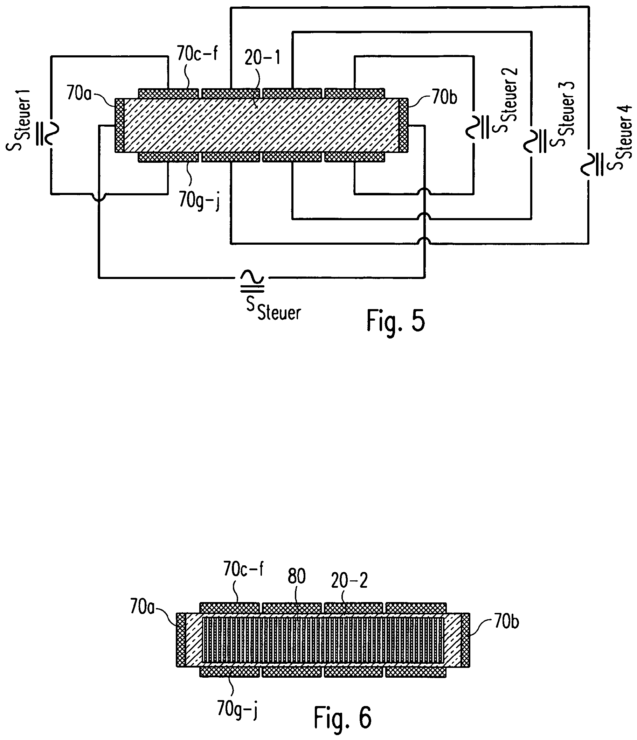

Der Erfindungsgedanke, eine Mehrzahl von Kontaktbereichen zum Anlegen eines Steuersignals vorzusehen, wird in den Ausführungsbeispielen von Fig.5 und Fig. 6 weiterentwickelt. In Fig. 5 und Fig. 6 ist jeweils eine schematische Draufsicht auf eine erste Elektrodenschicht 20-1 eines Leuchtkörpers 5 dargestellt, wobei neben den beiden lateral über den Leuchtbereich L₁₂ beabstandeten Kontaktbereichen 70a,70b eine Mehrzahl von weiteren Kontaktbereichen 70c-f und 70g-j, die jeweils paarweise in Querrichtung bezüglich der Verbindungslinie (zwischen den Kontaktbereichen 70a,70b) zueinander gegenüberliegend an der ersten Elektrodenschicht 20-1 angeordnet und mit der ersten Elektrodenschicht elektrisch verbunden sind. Erfindungsgemäß kann nun zwischen jedem gegenüberliegendem Paar von Kontaktbereichen 70c-f,70g-j jeweils ein weiteres Steuersignal S_{Steuer1}, S_{Steuer2} ,..., S_{Steuer4} angelegt werden, um so die Ladungsträgerverteilung über die Elektrode und somit die Leuchtdichte über den Leuchtbereich L₁₂ zu beeinflussen.

Fig. 6 zeigt ein weitere Ausführungsbeispiel, das sich gegenüber dem vorherigen Beispiel dadurch unterscheidet, dass die erste Elektrodenschicht 20-2 zusätzliche Strukturierungen aufweist. Durch die Ansteuerung mittels verschiedener Steuersignale und durch die Strukturierung der Elektrodenschicht werden komplexere Anzeigeelemente möglich. Zur Vereinfachung der Darstellung wurde in Fig. 6 die Darstellung der einzelnen Steuersignale weggelassen.

Durch die angelegten Steuersignale lässt sich nicht nur die Leuchtdichte über den Leuchtbereich des flächigen Leuchtkörpers kontrollieren, sondern auch der Farbverlauf. Optional kann die lichtemittierende Schicht 30 derart ausgebildet sein, dass der flächige Leuchtkörper bei unterschiedlicher Betriebsspannung S_{Betrieb} Licht mit einem unterschiedlichen Wellenlängenspektrum, insbesondere Licht unterschiedlicher Farbe, abstrahlt. So kann die lichtemittierde Schicht bei einer ersten Betriebsspannung A (bspw. 2,5 Volt) Licht mit einem ersten Wellenlängenspektrum und bei einer von der ersten Betriebsspannung unterschiedlichen zweiten Betriebsspannung B (bspw. 3,5 Volt) Licht mit einem zweiten Wellenlängenspektrum (insbesondere einer anderen Farbe), das sich vom ersten Wellenlängenspektrum unterscheidet, abgeben. Das Anlegen eines Steuersignals S_{Steuer} an eine Elektrodenschicht bewirkt, dass an verschiedenen Stellen des Leuchtbereichs L₁₂ effektiv eine unterschiedliche Betriebsspannung zwischen den Elektrodenschichten anliegt und sich dadurch das Wellenlängenspektrum des emittierten Lichts örtlich ändert. Durch Variation des Steuersignals kann also der Farbverlauf über den Leuchtbereich gesteuert werden. Wie bspw. in Fig. 4, Fig. 5 oder Fig. 6 dargestellt können natürlich mehrere Steuersignale S_{Steuer1,} S_{Steuer2} ,... an einer Mehrzahl von Kontaktbereichen an der ersten Elektrodenschicht angelegt werden, um den Farbverlauf über den Leuchtbereich mit einer besseren Ortsauflösung steuern zu können.
Zusammengefasst kann also eine Mehrzahl von Kontaktbereichen an den Randbereichen einer Elektrodenschicht jeweils voneinander lateral beabstandet angeordnet sein, über die ein oder mehrere Steuersignale anlegbar sind. Die einzelnen Kontaktbereiche können dabei selektiv ansteuerbar sein, sodass zwischen einem beliebigen Paar von Kontaktbereichen ein individuelles Steuersignal, bspw. in Form eines Spannungssignals, einer Steuerspannung oder eines Steuerstroms, angelegt werden kann. Die Kontaktbereiche können eine beliebige (geometrische) Form aufweisen und bevorzugt an die Geometrie des Leuchtbereichs angepasst sein. So können jeweils einzelne oder alle Kontaktbereiche im Wesentlichen punktförmig, oder streifenförmig oder entsprechend in Kombinationen davon ausgebildet sein. Durch eine größere Anzahl von Kontaktbereichen, an denen ein Steuersignal angelegt werden kann, kann die Leuchtdichteverteilung und/oder Farbverlauf mit einer besseren Ortsauflösung gesteuert werden. Optional kann eine Elektrodenschicht Strukturierungen aufweisen.

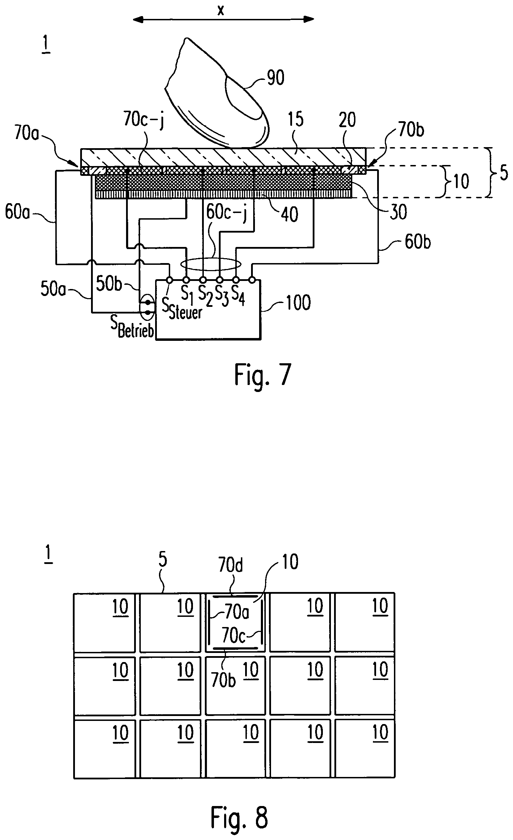

Erfindungsgemäß weist die Leuchtvorrichtung ferner Mittel auf, die eine Detektion einer Annäherung eines Objekts oder Berührung der Oberfläche des flächigen Leuchtkörpers erlauben. Indem eine Annäherung eines Objekts, Berührung der Oberfläche oder eine sonstige Bewegung erfasst wird, wird ermöglicht, dass die Steuerung der Helligkeit und/oder der Farbe bzw. des Helligkeits- und/oder Farbverlaufs des flächigen Leuchtkörpers interaktiv durch einen Benutzer erfolgen kann. So könnte bspw. die Leuchtvorrichtung durch eine entsprechende Handbewegung des Benutzers gedimmt werden. Ebenso kann durch eine entsprechende Handbewegung die Steuerung des Helligkeits- und/oder Farbverlaufs durch einen Benutzer erfolgen. Die Detektion einer Annäherung oder Berührung erfolgt durch eine Kapazitätserfassungseinrichtung. In Fig. 7 ist eine schematische Seitenansicht einer Leuchtvorrichtung 1 mit einem berührungsempfindlichen flächigen Leuchtkörper dargestellt, gemäß der beanspruchten Erfindung. Die Leuchtvorrichtung weist zur ortsaufgelösten Detektion einer Annäherung eines Objekts oder Berührung eine Kapazitätserfassungseinrichtung auf. Dabei werden die Kontaktbereiche 70a-j an der ersten Elektrodenschicht, über die ein Steuersignal anlegbar ist, durch eine geeignete Ansteuerung und Auswertung auch zur Erfassung eines Kapazitätsparameters verwendet. Eine Ansteuer- und Erfassungseinrichtung 100 ist mit den Kontaktbereichen 70a-j so verbunden, um einerseits Steuersignale zur Beeinflussung des Leuchtdichte- und/oder Farbverlaufs bereitzustellen als auch kapazitive Messgrößen zu erfassen, die sich bei einer Berührung oder Annäherung der Substratoberfläche 15 ändern. Nähert sich nun ein Objekt 90, bspw. ein Finger oder ein Stift, der Substratoberfläche oder berührt diese, findet bspw. zwischen den Kontaktbereichen 70a-j und einem Bezugspotential (bspw. dem Massepotential) eine Kapazitätsänderung statt, die elektronisch erfasst werden kann. Durch die Mehrzahl von Kontaktbereichen 70a-j kann die Position des Objekt ortsaufgelöst detektiert werden.
Damit die Leuchtvorrichtung sowohl zur Lichtabgabe als auch zur Erfassung der Position des Objekts verwendet werden kann, kann die Ansteuer- und Erfassungseinrichtung 100 abwechselnd in einer Leuchtphase, in der Licht abgegeben wird, und in einer Phase, in der die Position des Objekts 90 erfasst wird, arbeiten. Während der Leuchtphase wird der Leuchtkörper mit einem geeigneten Betriebsstrom betrieben und es werden optional Steuersignale zur Leuchtdichtesteuerung an eine Elektrodenschicht angelegt. Während der Positionserfassung-Phase erfolgt die kapazitive Erfassung der Position des Objekts bezüglich der Kontaktbereiche 70a-j und der Leuchtkörper leuchtet nicht. Damit das Abschalten des Lichts vom Anwender nicht wahrgenommen werden kann, sollte ausreichend schnell zwischen diesen beiden Phasen umgeschaltet werden, bspw. mit einer Frequenz von 25 Hz oder mehr, und die Phase, während der Leuchtkörper nicht leuchtet, sollte ausreichend kurz sein.

In dem vorigen Ausführungsbeispiel ist die Erfindung anhand von einer Leuchtvorrichtung vorgestellt worden, die einen einzelnen flächigen Leuchtkörper mit einem einzelnen Leuchtbereich, dessen Leuchtdichteverlauf variierbar ist, aufweist. Die Erfindung umfasst weiters auch Leuchtvorrichtungen, in denen der Leuchtbereich segmentiert ist und mehrere Leuchtbereiche aufweist, die jeweils individuell ansteuerbar sind und deren Leuchtdichteverlauf individuell variierbar ist. Eine derartige Leuchtvorrichtung kann bspw. dadurch realisiert werden, dass mehrere flächige Leuchtkörper, wie sie in den vorangehenden Ausführungsbeispielen beschrieben wurden, zu einer Leuchtvorrichtung zusammengefasst werden. Alternativ kann die Leuchtvorrichtung auch bspw. durch einen einzelnen flächigen Leuchtkörper realisiert werden, bei dem mehrere Schichtanordnungen 10 nebeneinander an einem Substrat angeordnet sind, die dann selektiv ansteuerbar sind.
Fig. 8 zeigt nun ein derartiges Ausführungsbeispiel, bei dem die Leuchtvorrichtung 1 durch einen flächigen Leuchtkörper 5 gebildet wird, der eine Vielzahl von Schichtanordnungen 10 mit jeweils einem Leuchtbereich aufweist. Die einzelnen Schichtanordnungen 10 weisen dabei jeweils Kontaktbereiche 70a-d auf, an denen jeweils Steuersignale anlegbar sind, um die Leuchtdichteverteilung des einzelnen Leuchtbereichs zu steuern. Mittels einer geeigneten Ansteuer- und Erfassungseinrichtung kann nun über eine verhältnismäßig große Fläche einerseits das Abstrahlverhalten mit einer guten Ortsauflösung gesteuert werden, andererseits kann durch entsprechende Elektronik auch eine Annäherung eines Objekts oder Berührung der Oberfläche mit guter Ortsauflösung erfasst werden.

## Patentansprüche

1. Leuchtvorrichtung (1) mit folgenden Merkmalen:
einem flächigen Leuchtkörper (5), der eine einen Leuchtbereich (L₁₂) bildende Schichtanordnung (10) mit einer ersten Elektrodenschicht (20; 20-1; 20-2; 20-3), einer zweiten Elektrodenschicht (40) und mindestens einer lichtemittierenden Zwischenschicht (30), die zwischen der ersten Elektrodenschicht (20; 20-1; 20-2; 20-3) und der zweiten Elektrodenschicht (40) angeordnet ist, aufweist, wobei die erste Elektrodenschicht (20; 20-1; 20-2; 20-3) mindestens zwei lateral über den Leuchtbereich (L12) hinweg beabstandete Kontaktbereiche (70a,70b) aufweist, an die mittels einer Signalquelle (60) ein elektrisches Steuersignal (Ssteuer) anlegbar ist,
eine Signalquelle (60) zum Anlegen eines elektrischen Steuersignals (S_{Steuer}) an die erste Elektrodenschicht (20; 20-1; 20-2; 20-3) über die zwei lateral beabstandeten Kontaktbereiche (70a, 70b).
**dadurch gekennzeichnet,**
**dass** die Leuchtvorrichtung weiters eine Kapazitätserfassungseinrichtung zur ortsaufgelösten Detektion einer Annäherung eines Objekts oder einer Berührung durch Erfassen eines Kapazitätsparameters an den Kontaktbereichen (70a-j) aufweist.

2. Leuchtvorrichtung nach Anspruch 1, wobei mittels des Steuersignals (Ssteuer) zwischen zwei über den Leuchtbereich lateral beabstandeten Kontaktbereichen (70a,70b) ein Spannungsgefälle über die Elektrodenschicht (20; 20-1; 20-2: 20-3) in lateraler Richtung einstellbar ist, um die Leuchtdichte- und/oder Farbverteilung über den Leuchtbereich (L₁₂) zu beeinflussen.

3. Leuchtvorrichtung nach Anspruch 1 oder 2, wobei die erste Elektrodenschicht (20; 20-1; 20-2; 20-3) eine Mehrzahl weiterer Kontaktbereiche (70c-j) aufweist, die jeweils voneinander lateral beabstandet angeordnet sind, wobei zwischen mindestens einem Paar von Kontaktbereichen (70a,70b,70c-j) ein Steuersignal (S_{Steuer}) anlegbar ist.

4. Leuchtvorrichtung nach Anspruch 3, wobei mittels einer Ansteuerelektronik mehrere Steuersignale (S_{Steuer1}, S_{Steuer2},..., S_{Steuer4}) zwischen verschiedenen Paaren von Kontaktbereichen (70a,70b,70c-j) anlegbar sind, um die Leuchtdichte- und/oder Farbverteilung über den Leuchtbereich mit besserer Ortsauflösung zu beeinflussen.

5. Leuchtvorrichtung nach einem der vorhergehenden Ansprüche, wobei mindestens eine Elektrodenschicht strukturiert ausgebildet ist.

6. Leuchtvorrichtung nach Anspruch 5, wobei mindestens eine Elektrodenschicht eine Folge von Aussparungen (80) entlang einer Verbindungslinie zwischen den zwei lateral über den Leuchtbereich (L₁₂) hinweg beabstandeten Kontaktbereichen (70a,70b) aufweist.

7. Leuchtvorrichtung nach Anspruch 6, wobei die Aussparungen (80) rechteckig und quer bezüglich der Verbindungslinie zueinander beabstandet sind,
und wobei vorzugsweise die Aussparungen (80) gleich beabstandet und gleich groß sind.

8. Leuchtvorrichtung nach einem der vorhergehenden Ansprüche, wobei die Mehrzahl von weiteren Kontaktbereichen (70c-f, 70g-j) jeweils paarweise in Querrichtung bezüglich der Verbindungslinie zueinander gegenüberliegend an der ersten Elektrodenschicht (20; 20-1; 20-2; 20-3) angeordnet sind.

9. Leuchtvorrichtung nach einem der vorhergehenden Ansprüche, die eine Ansteuer- und Erfassungseinrichtung (100) aufweist, die ausgebildet ist, um basierend auf dem erfassten Kapazitätsparameter die Position eines Objekts, welches sich der Leuchtvorrichtung annähert oder die Oberfläche der Leuchtvorrichtung berührt, zu ermitteln.

10. Leuchtvorrichtung nach einem der vorhergehenden Ansprüche, wobei die erste Elektrodenschicht (70a,70b,70c-j) transparent ausgebildet ist.

11. Leuchtvorrichtung nach einem der vorhergehenden Ansprüche, wobei der flächige Leuchtkörper durch eine organische Leuchtdiode gebildet wird.

12. Verfahren zur Steuerung der Leuchtdichte- und/oder Farbverteilung des Leuchtbereichs (L₁₂) einer Leuchtvorrichtung (1), wobei die Leuchtvorrichtung (1) einen flächigen Leuchtkörper (5) aufweist, der eine einen Leuchtbereich bildende Schichtanordnung (10) mit einer ersten Elektrodenschicht (20; 20-1; 20-2; 20-3), einer zweiten Elektrodenschicht (40) und mindestens einer lichtemittierenden Zwischenschicht (30), die zwischen der ersten Elektrodenschicht (20; 20-1; 20-2; 20-3) und der zweiten Elektrodenschicht (40) angeordnet ist, aufweist, wobei die erste Elektrodenschicht (20; 20-1; 20-2; 20-3) mindestens zwei lateral über den Leuchtbereich (L₁₂) hinweg beabstandete Kontaktbereiche (70a,70b) aufweist, **gekennzeichnet durch** den folgenden Schritten: Anlegen eines Steuersignals (Ssteuer) an die erste Elektrodenschicht (20; 20-1; 20-2; 20-3) über die zwei lateral beabstandeten Kontaktbereiche (70a,70b) und Erfassen mindestens eines Kapazitätsparameters an den Kontaktbereichen (70a-j) der ersten Elektrodenschicht zur ortsaufgelösten Detektion einer Annäherung eines Objekts oder einer Berührung.

13. Verfahren nach Anspruch 12, ferner mit folgendem Schritt:
Ermitteln der Position eines Objekts, welches sich der Leuchtvorrichtung annähert oder die Oberfläche der Leuchtvorrichtung berührt, basierend auf dem erfassten Kapazitätsparameter,
wobei vorzugsweise die Leuchtdichte- und/oder Farbverteilung der Leuchtvorrichtung in Abhängigkeit von der Position des Objekts gesteuert wird.

## Claims

1. Luminous apparatus (1) having the following features:
a planar luminous body (5), having a layer arrangement (10), which forms a luminous region (L₁₂), with a first electrode layer (20; 20-1; 20-2; 20-3), a second electrode layer (40) and at least one light-emitting intermediate layer (30), which is arranged between the first electrode layer (20; 20-1; 20-2; 20-3) and the second electrode layer (40), wherein the first electrode layer (20; 20-1; 20-2; 20-3) has at least two contact regions (70a, 70b) which are laterally spaced apart across the luminous region (L₁₂) and to which an electrical control signal (S_{control}) is able to be applied using a signal source (60),
a signal source (60) for applying an electrical control signal (S_{control}) to the first electrode layer (20; 20-1; 20-2; 20-3) via the two laterally spaced-apart contact regions (70a, 70b),
**characterized in that** the luminous apparatus furthermore has a capacitance capturing device for spatially resolved detection of an approach of an object or a touch by capturing a capacitance parameter at the contact regions (70a-j).

2. Luminous apparatus according to Claim 1, wherein the control signal (S_{control}) is able to be used to set a voltage drop across the electrode layer (20; 20-1; 20-2; 20-3) in the lateral direction between two contact regions (70a, 70b) which are laterally spaced apart over the luminous region in order to influence the luminance and/or colour distribution over the luminous region (L₁₂) .

3. Luminous apparatus according to Claim 1 or 2, wherein the first electrode layer (20; 20-1; 20-2; 20-3) has a plurality of further contact regions (70c-j), which are each arranged to be laterally spaced apart from one another, wherein a control signal (S_{control}) is able to be applied between at least one pair of contact regions (70a, 70b, 70c-j).

4. Luminous apparatus according to Claim 3, wherein a plurality of control signals (S_{control1}, S_{control12},..., S_{control4}) are able to be applied between different pairs of contact regions (70a, 70b, 70c-j) using control electronics to influence the luminance and/or colour distribution over the luminous region with better spatial resolution.

5. Luminous apparatus according to one of the preceding claims, wherein at least one electrode layer has a structured form.

6. Luminous apparatus according to Claim 5, wherein at least one electrode layer has a sequence of cutouts (80) along a connecting line between the two contact regions (70a, 70b), which are laterally spaced apart across the luminous region (L₁₂) .

7. Luminous apparatus according to Claim 6, wherein the cutouts (80) are rectangular and spaced apart from one another transversely with respect to the connecting line, and wherein preferably the cutouts (80) are equally spaced apart and of equal size.

8. Luminous apparatus according to one of the preceding claims, wherein the plurality of further contact regions (70c-f, 70g-j) are arranged mutually opposite one another at the first electrode layer (20; 20-1; 20-2; 20-3) in each case in pairs in the transverse direction with respect to the connecting line.

9. Luminous apparatus according to one of the preceding claims, having a control and capturing device (100), which is embodied to ascertain, based on the captured capacitance parameter, the position of an object which approaches the luminous apparatus or touches the surface of the luminous apparatus.

10. Luminous apparatus according to one of the preceding claims, wherein the first electrode layer (70a, 70b, 70c-j) has a transparent form.

11. Luminous apparatus according to one of the preceding claims, wherein the planar luminous body is formed by an organic light-emitting diode.

12. Method for controlling the luminance and/or colour distribution of the luminous region (L₁₂) of a luminous apparatus (1), wherein the luminous apparatus (1) has a planar luminous body (5) which has a layer arrangement (10), which forms a luminous region, with a first electrode layer (20; 20-1; 20-2; 20-3), a second electrode layer (40) and at least one light-emitting intermediate layer (30), which is arranged between the first electrode layer (20; 20-1; 20-2; 20-3) and the second electrode layer (40), wherein the first electrode layer (20; 20-1; 20-2; 20-3) has at least two contact regions (70a, 70b) which are laterally spaced apart across the luminous region (L₁₂), **characterized by** the following steps:
applying a control signal (S_{control}) to the first electrode layer (20; 20-1; 20-2; 20-3) via the two laterally spaced-apart contact regions (70a, 70b) and capturing at least one capacitance parameter at the contact regions (70a-j) of the first electrode layer for spatially resolved detection of an approach of an object or of a touch.

13. Method according to Claim 12, furthermore having the following step:
ascertaining the position of an object, which approaches the luminous apparatus or touches the surface of the luminous apparatus, based on the captured capacitance parameter,
wherein the luminance and/or colour distribution of the luminous apparatus is preferably controlled in dependence on the position of the object.

## Revendications

1. Appareil d'éclairage (1) comprenant les caractéristiques suivantes :
un corps lumineux (5) plat, comportant une configuration de couches (10) formant une zone éclairante (L₁₂) et dotée d'une première couche d'électrode (20 ; 20-1 ; 20-2 ; 20-3), d'une deuxième couche d'électrode (40) et d'au moins une couche intermédiaire (30) émettrice de lumière, agencée entre la première couche d'électrode (20 ; 20-1 ; 20-2 ; 20-3) et la deuxième couche d'électrode (40), dans lequel la première couche d'électrode (20 ; 20-1 ; 20-2 ; 20-3) comporte au moins deux zones de contact (70a, 70b) espacées latéralement au-delà de la zone éclairante (L₁₂), auxquelles un signal de commande électrique (S_{Commande}) peut être appliqué au moyen d'une source de signal (60),
une source de signal (60) destinée à appliquer un signal de commande électrique (S_{Commande}) à la première couche d'électrode (20 ; 20-1 ; 20-2 ; 20-3) par le biais des deux zones de contact (70a, 70b) espacées latéralement, **caractérisé en ce que**
l'appareil d'éclairage comporte en outre un dispositif de saisie de capacitance destiné à la détection spatialement résolue d'un rapprochement d'un objet ou d'un contact par le biais de la saisie d'un paramètre de capacitance sur les zones de contact (70a-j).

2. Appareil d'éclairage selon la revendication 1, dans lequel au moyen du signal de commande (S_{Commande}) un gradient de potentiel sur la couche d'électrode (20 ; 20-1 ; 20-2 ; 20-3) est réglable dans la direction latérale entre deux zones de contact (70a, 70b) espacées latéralement par le biais de la zone éclairante, afin d'influencer la distribution de la luminance et/ou des couleurs sur la zone éclairante (L₁₂).

3. Appareil d'éclairage selon la revendication 1 ou 2, dans lequel la première couche d'électrode (20 ; 20-1 ; 20-2 ; 20-3) comporte une pluralité de zones de contact supplémentaires (70c-j), lesquelles sont agencées respectivement de manière espacée latéralement les unes des autres, dans lequel un signal de commande (S_{Commande}) peut être appliqué entre au moins une paire de zones de contact (70a, 70b, 70c-j).

4. Appareil d'éclairage selon la revendication 3, dans lequel au moyen d'une électronique de commande plusieurs signaux de commande (S_{Commande1}, S_{Sommande2}, ..., S_{Commande4}) peuvent être appliqués entre différentes paires de zones de contact (70a, 70b, 70c-j), afin d'influencer la distribution de la luminance et/ou des couleurs sur la zone éclairante avec une meilleure résolution spatiale.

5. Appareil d'éclairage selon l'une des revendications précédentes, dans lequel au moins une couche d'électrode est conçue de façon structurée.

6. Appareil d'éclairage selon la revendication 5, dans lequel au moins une couche d'électrode comporte une suite de cavités (80) le long d'une ligne de connexion entre les deux zones de contact (70a,70b) espacées latéralement au-delà de la zone éclairante (L₁₂) .

7. Appareil d'éclairage selon la revendication 6, dans lequel les cavités (80) sont rectangulaires et sont espacées les unes des autres transversalement par rapport à la ligne de connexion et dans lequel de préférence les cavités (80) sont de même taille et sont espacées de manière identique.

8. Appareil d'éclairage selon l'une des revendications précédentes, dans lequel la pluralité de zones de contact supplémentaires (70c-f, 70g-j) sont agencées respectivement en regard les unes des autres par paires dans la direction transversale par rapport à la ligne de connexion sur la première couche d'électrode (20 ; 20-1 ; 20-2 ; 20-3).

9. Appareil d'éclairage selon l'une des revendications précédentes, comportant un dispositif de commande et de saisie (100), lequel est conçu pour déterminer, en se basant sur le paramètre de capacitance saisi, la position d'un objet s'approchant de l'appareil d'éclairage ou touchant la surface de l'appareil d'éclairage.

10. Appareil d'éclairage selon l'une des revendications précédentes, dans lequel la première couche d'électrode (70a, 70b, 70c-j) est conçue de manière transparente.

11. Appareil d'éclairage selon l'une des revendications précédentes, dans lequel le corps lumineux plat est formé par une diode électroluminescente organique.

12. Procédé de commande de la distribution de la luminance et/ou des couleurs de la zone éclairante (L₁₂) d'un appareil d'éclairage (1),
dans lequel l'appareil d'éclairage (1) comporte un corps lumineux (5) plat, comportant une configuration de couches (10) formant une zone éclairante et dotée d'une première couche d'électrode (20 ; 20-1 ; 20-2 ; 20-3), d'une deuxième couche d'électrode (40) et d'au moins une couche intermédiaire (30) émettrice de lumière, agencée entre la première couche d'électrode (20 ; 20-1 ; 20-2 ; 20-3) et la deuxième couche d'électrode (40), dans lequel la première couche d'électrode (20 ; 20-1 ; 20-2 ; 20-3) comporte au moins deux zones de contact (70a, 70b) espacées latéralement au-delà de la zone éclairante (L₁₂), **caractérisé par** les étapes suivantes :
application d'un signal de commande (S_{Commande}) à la première couche d'électrode (20 ; 20-1 ; 20-2 ; 20-3) par le biais des deux zones de contact (70a, 70b) espacées latéralement et saisie d'au moins un paramètre de capacitance sur les zones de contact (70a-j) de la première couche d'électrode à des fins de détection spatialement résolue d'un rapprochement d'un objet ou d'un contact.

13. Procédé selon la revendication 12 comprenant en outre l'étape suivante :
détermination de la position d'un objet s'approchant de l'appareil d'éclairage ou touchant la surface de l'appareil d'éclairage, en se basant sur le paramètre de capacitance saisi,
dans lequel la distribution de la luminance et/ou des couleurs de l'appareil d'éclairage est commandée de préférence en fonction de la position de l'objet.
